# EUROPÄISCHE PATENTANMELDUNG

(11) **EP 1 971 197 A2**
(43) Veröffentlichungstag der Anmeldung: **17.09.2008**
(21) Anmeldenummer: 08101004.3
(22) Anmeldetag: 28.01.2008
(51) Int. Cl.: H05K 13/00

(54) **Unterstützung von zwei mit einem Doppel-Transportsystem bereitgestellten zu bestückenden Substraten mit unterschiedlicher Breite**

(30) Priorität: 14.03.2007 DE 102007012364
(71) Anmelder: SIEMENS AKTIENGESELLSCHAFT, 80333 München (DE)
(72) Erfinder: Dietrich, Stefan, 76149, Karlsruhe (DE); Stützer, Roland, 589630 Singapore (SG); Zimmermann, Bernd, 76297, Stutensee/Blankenloch (DE)

(57) **Zusammenfassung**

Die vorliegende Anmeldung beschreibt eine Hubvorrichtung für ein Transportsystem zum Transportieren von Substraten entlang einer Transportrichtung (T), wobei das Transportsystem eine erste Transportspur (211) mit einer ersten Spurbreite zum Transport von ersten Substraten und eine zweite Transportspur (212) mit einer zu der ersten Spurbreite unterschiedlichen zweiten Spurbreite zum Transport von zweiten Substraten aufweist. Die Hubvorrichtung (200) weist auf ein erstes Hubelement (221), welches der ersten Transportspur (211) des Transportsystems zugeordnet ist, und ein zweites Hubelement (222), welches der zweiten Transportspur (212) des Transportsystems zugeordnet ist. Die Hubvorrichtung (200) weist ferner auf zumindest ein erstes Unterstützungselement (226, 228), welches an dem ersten Hubelement (221) angebracht ist und welches derart eingerichtet ist, bei einer geeigneten Positionierung des ersten Hubelements (221) ein erstes Substrat zu unterstützen, und zumindest ein zweites Unterstützungselement (227), welches an dem zweiten Hubelement (222) angebracht ist und welches derart eingerichtet ist, bei einer geeigneten Positionierung des zweiten Hubelements (222) ein zweites Substrat zu unterstützen. Dabei sind die beiden Hubelemente (221, 222) unabhängig voneinander positionierbar.

## Beschreibung

Die vorliegende Erfindung betrifft die Bestückung von Bauelementeträgern bzw. Substraten oder Leiterplatten mit elektronischen Bauelementen. Insbesondere betrifft die vorliegende Erfindung eine Hubvorrichtung, mittels welcher in einen Bestückbereich einer Bestückvorrichtung eingebrachte Substrate unterstützt werden können, um so ein unerwünschtes Durchbiegen der Substrate während des Bestückprozesses zu verhindern. Die vorliegende Erfindung betrifft ferner ein Transportsystem zum Zuführen von zu bestückenden Substraten in einen Bestückbereich und zum Abtransportieren von zumindest teilweise bestückten Substraten entlang zweier Transportspuren. Ferner betrifft die vorliegende Erfindung eine Bestückvorrichtung mit einem derartigen Transportsystem.

Die Bestückung von Bauelementeträgern, welche auch als Substrate oder Leiterplatten bezeichnet werden, erfolgt üblicherweise mittels automatischer Bestückvorrichtungen. Die Bestückung umfasst dabei ein Zuführen von zu bestückenden Substraten in einen Bestückbereich, das Bestücken der Substrate mittels eines Bestückkopfes und das Abführen der zumindest teilweise bestückten Substrate aus dem Bestückbereich. Bei der eigentlichen Bestückung werden von einer Bauelement-Zuführeinrichtung bereitgestellte elektronische Bauelemente von dem Bestückkopf abgeholt, in den Bestückbereich transportiert und an vorgegebene Stellen auf das in dem Bestückbereich befindliche Substrat aufgesetzt.

Um die Effizienz, d.h. die Anzahl an Bauelementen, welche innerhalb einer vorgegebenen Zeiteinheit abgeholt, transportiert und aufgesetzt werden können, zu erhöhen, wurden Bestückvorrichtungen entwickelt, welche so genannte Doppel-Transportssysteme und zumindest zwei Bestückkopfe aufweisen. Mit derartigen Maschinen können Substrate auf unterschiedlichen Transportspuren in einen jeweiligen Bestückbereich eingefahren, bestückt und abtransportiert werden.

SIPLACE Bestückvorrichtungen der Firma Siemens können alternativ mit einem Einfach-Transportssystem oder mit einem Doppel-Transportssystem ausgestattet werden. Eine Bestückvorrichtung mit einem Doppel-Transportssystem kann in einem vollständig asynchronen Modus betrieben werden, wobei dann jede Transportspur in Verbindung mit einem entsprechenden Bestückkopf und einer entsprechenden Bauelement-Zuführeinrichtung wir ein autarkes Bestücksystem arbeiten kann. Um verschieden breite Substrate bestücken zu können, sind die Spurbreiten der beiden Transportspuren des Doppel-Transportssystems verstellbar. Dabei ist jedoch die maximal einstellbare Spurbreite kleiner als 50% der Gesamtbreite bzw. kleiner als 50% der maximalen Breite eines entsprechenden Einzel-Transportsystems.

Die EP 0854 670 B1 offenbart eine Fördereinrichtung für Leiterplatten, bei der die Leiterplatte mit beiden Seitenrändern auf zwei schmalen Transportriemen aufliegt, die in einer Förderschiene geführt sind. Um die Transportstrecke auf unterschiedliche Breiten von Leiterplatten einstellen zu können, ist eine der beiden Förderschienen mittels eines umlaufenden Gurtes quer zu Transportrichtung der Leiterplatten verschiebbar. Dabei ist ein Mitnehmer der verschiebbaren Förderschiene fest mit dem Gurt verbunden. Der Gurt kann mittels eines Antriebsmotors in entgegen gesetzte Richtungen angetrieben werden und dabei den Abstand zwischen der festen und der beweglichen Förderschiene vergrößern oder verkleinern.

Die EP 1 185 156 A1 offenbart eine breitenverstellbare Fördereinrichtung zum Transportieren von Substraten in einer Bestückvorrichtung, welche zwei Transportstrecken mit jeweils zwei zueinander parallelen Förderschienen aufweist. Die Förderschienen sind mittels einer Schaltkupplung selektiv an eine senkrecht zur Transportrichtung orientierte Verstellspindel ankoppelbar. Auf diese Weise können die Spurbreiten der beiden Transportstrecken individuell eingestellt werden und so die gesamte Fördereinrichtung an verschiedene Substratgrößen angepasst werden.

Die WO 2003/078282 offenbart eine breitenverstellbare Fördereinrichtung zum Transportieren von Substraten in einer Bestückvorrichtung, welche zumindest eine Transportstrecke mit mindestens zwei zueinander parallelen Förderschienen aufweist. Das Substrat liegt auf beiden Förderschienen auf. Zumindest eine der beiden Förderschienen ist quer zur Transportrichtung der Transportstrecke mittels zumindest eines umlaufenden Zugmittels verschiebbar, welches an die verschiebbare Förderschiene ankoppelbar ist. Quer zur Transportrichtung erstreckt sich eine zum Zugmittel parallele Fixierschiene für die verschiebbare Förderschiene, welche wechselweise mit dem Zugmittel und der Fixierschiene koppelbar ist. Die Förderschienen lassen sich abwechselnd oder gleichzeitig quer zur Transportrichtung um eine vorbestimmte Wegstrecke verschieben und somit automatisch auf eine neue Position einstellen. Im Falle eines so genannten Doppeltransportes mit zwei Transportstrecken und vier Förderschienen ist es möglich, die beiden mittleren Förderschienen vollständig auf eine Seite zu verschieben, so dass die zur Verfügung stehende Restbreite der Fördereinrichtung den Transport von annähernd doppelt breiten Substraten ermöglicht.

Bei einer derartigen Erhöhung der zur Verfügung stehenden Restbreite werden zur notwendigen Unterstützung eines entsprechend breiten Substrates während der eigentlichen Bestückung zwei Hubtische quasi parallel geschaltet, so dass das Substrat mit beiden Hubtischen durch Klemmen in der Bestückposition fixiert werden kann. Dies hat jedoch den Nachteil, dass die zweite kleinere Transportspur für eine Bestückung von kleineren Substraten nicht mehr zur Verfügung steht und somit die Effektivität der entsprechenden Bestückvorrichtung reduziert wird.

Der Erfindung liegt die Aufgabe zugrunde, eine Hubvorrichtung zu schaffen, welche in Verbindung mit einem Doppel-Transportsystem eine effektive Bestückung auch von ungleich breiten Substraten ermöglicht.

Diese Aufgabe wird gelöst durch die Gegenstände der unabhängigen Patentansprüche. Vorteilhafte Ausführungsformen der vorliegenden Erfindung sind in den abhängigen Ansprüchen beschrieben.

Mit dem unabhängigen Patentanspruch 1 wird eine Hubvorrichtung für ein Transportsystem zum Transportieren von Substraten entlang einer Transportrichtung beschrieben, wobei das Transportsystem eine erste Transportspur mit einer ersten Spurbreite zum Transport von ersten Substraten und eine zweite Transportspur mit einer zu der ersten Spurbreite unterschiedlichen zweiten Spurbreite zum Transport von zweiten Substraten aufweist. Die beschriebene Hubvorrichtung, welche sich insbesondere zum Transportieren von Substraten in einer Bestückvorrichtung zum automatischen Bestücken der Substrate mit Bauelementen eignet, weist auf (a) ein erstes Hubelement, welches der ersten Transportspur des Transportsystems zugeordnet ist, (b) ein zweites Hubelement, welches der zweiten Transportspur des Transportsystems zugeordnet ist, (c) zumindest ein erstes Unterstützungselement, welches an dem ersten Hubelement angebracht ist und welches derart eingerichtet ist, bei einer geeigneten Positionierung des ersten Hubelements ein erstes Substrat zu unterstützen, und (d) zumindest ein zweites Unterstützungselement, welches an dem zweiten Hubelement angebracht ist und welches derart eingerichtet ist, bei einer geeigneten Positionierung des zweiten Hubelements ein zweites Substrat zu unterstützen.

Dabei sind die beiden Hubelemente unabhängig voneinander positionierbar.

Der beschriebenen Hubvorrichtung liegt die Erkenntnis zugrunde, dass durch eine Anpassung der Hubelemente und/oder der entsprechenden Unterstützungselemente an die Asymmetrie eines so genannten Doppel-Transportsystems eine unabhängige Unterstützung von unterschiedlich dimensionierten Substraten ermöglicht wird, die in der ersten Transportspur bzw. in der zweiten Transportspur einem Bestückbereich einer Bestückvorrichtung zugeführt werden. Auf diese Weise können beide Transportspuren auch bei einer permanent vorhandenen bzw. bei einer vorübergehend eingestellten Asymmetrie des Transportsystems unabhängig voneinander betrieben werden. Dies gilt auch dann, wenn die breitere der beiden Transportspuren eine Breite aufweist, die größer ist als die Hälfte der Gesamtbreite des Transportsystems.

Durch eine geeignete Unterstützung der zu bestückenden Substrate kann gewährleistet werden, dass sich die in dem jeweiligen Bestückbereich befindlichen Substrate nicht versehentlich durchbiegen und somit unabhängig von der Größe und der mechanischen Stabilität des jeweiligen Substrates die Bestückebene genau definiert ist. Dies gilt auch dann, wenn Bauelementen mittels eines Bestückkopfes mit unterschiedlichen Aufsetzkräften auf dem Substrat aufgesetzt werden. Die Bestückebene ist dabei die Ebene, die durch die Oberseite des zu bestückenden Substrates definiert ist.

Die Hubelemente sind bevorzugt jeweils eine Platte, die auch als so genannte Hubtischplatte bezeichnet werden kann. Diese kann in bekannter Weise mittels geeigneten Hub- bzw. Vertikalantrieben von unten an eine abzustützende Leiterplatte herangeführt werden.

Die Unterstützungselemente können jeweils mittels eines Stiftes realisiert werden, welcher beispielsweise eine Länge von 90 mm und einen Durchmesser von 8 mm aufweist. Um die Unterstützungselemente im Hinblick auf unterschiedliche Substrate bzw. deren Bestückinhalt geeignet positionieren zu können, können die Unterstützungsstifte einen Magnetfuß aufweisen, der, sofern die Hubelemente ein magnetisches Material aufweisen, frei an den Hubelementen positionierbar ist.

Gemäß einem Ausführungsbeispiel der Erfindung nach Anspruch 2 weist die Hubvorrichtung zusätzlich auf (a) zumindest einen ersten Vertikalantrieb, eingerichtet zum vertikalen Positionieren des ersten Hubelements und (b) zumindest einen zweiten Vertikalantrieb, eingerichtet zum vertikalen Positionieren des zweiten Hubelements. Dabei sind der erste Vertikalantrieb und der zweite Vertikalantrieb in Bezug auf eine Längsmittelachse des gesamten Doppel-Transportsystems symmetrisch zueinander angeordnet.

Dies hat den Vorteil, dass die beschriebene Hubvorrichtung mit Vertikalantrieben betrieben werden kann, die entsprechend einer üblichen symmetrischen Anordnung von zwei gleich großen Hubtischplatten in Verbindung mit herkömmlichen symmetrischen Doppel-Transportsystemen in bekannten Bestückvorrichtungen ohnehin vorhanden sind. Ein unabhängiger Substrattransport in Verbindung mit einem asymmetrischen Transportsystem und entsprechenden Hubelementen zur Unterstützung der in der Bestückposition befindlichen Substrate kann somit auch bei herkömmlichen Bestückvorrichtungen ohne große Umbaumaßnahmen bzw. Umbaukosten realisiert werden. Erforderlich ist lediglich die Verwendung von zwei ungleichen Hubelementen bzw. zwei ungleichen Unterstützungselementen.

Bevorzugt sind für jedes Hubelement jeweils vier Vertikalantriebe vorgesehen, die gemeinsam ein gleichmäßiges Anheben bzw. ein Absenken des jeweiligen Hubelements ermöglichen. Auf diese Weise kann eine versehentliche Verkippung des Hubelements einfach verhindert werden. Die vier Vertikalantriebe können jeweils einen eigenen Motor aufweisen. Alternativ können die jeweils einem Hubelement zugeordneten Vertikalantriebe auch über jeweils eine geeignete Antriebskinetik mit einem gemeinsamen zentralen Antriebsmotor gekoppelt sein. Dies hat den Vorteil, dass auf einfache Weise eine gleichmäßige Bewegung aller Vertikalantriebe gewährleistet und eine unerwünschte Verkippung des Hubelements während der Positionierung zuverlässig verhindert werden kann.

Gemäß einem weiteren Ausführungsbeispiel der Erfindung nach Anspruch 3 weist die Hubvorrichtung zusätzlich auf (a) zumindest eine erste Klemmeinrichtung und ein erstes Mitnehmerelement, welche bei einem Anheben des ersten Hubelements derart zusammenwirken, dass ein erstes Substrat in einer ersten Bestückposition fixierbar ist, und (b) zumindest eine zweite Klemmeinrichtung und ein zweites Mitnehmerelement, welche bei einem Anheben des zweiten Hubelements derart zusammenwirken, dass ein zweites Substrat in einer zweiten Bestückposition fixierbar ist.

Dies hat den Vorteil, dass unerwünschte Verschiebungen des ersten und des zweiten Substrates während eines Bestückungsvorgangs, der insbesondere mehrere Aufsetzvorgänge umfasst, auf einfache und zuverlässige Weise vermieden werden können. Für eine entsprechende Klemmung der Substrate sind somit keine eigene Aktuatoren bzw. Stellantriebe erforderlich. Zur Betätigung einer Klemmeinrichtung wird vielmehr in vorteilhafter Weise die Bewegung des jeweiligen Hubelements ausgenutzt.

Für jede Transportspur können mehrere Klemmeinrichtungen und Mitnehmerelemente verwendet werden, so dass eine Klemmung an verschiedenen Stellen des jeweiligen Substrates möglich ist. Bevorzugt werden für jede Transportspur vier Klemmeinrichtungen und Mitnehmerelemente verwendet, so dass die zu bestückenden Substrate an vier Stellen, die in der Nähe der Substratecken angeordnet sein können, fixiert werden können.

Gemäß einem weiteren Ausführungsbeispiel der Erfindung nach Anspruch 4 weist das erste Hubelement zumindest in Teilbereichen senkrecht zur Transportrichtung eine größere Breite auf als das zweite Hubelement. Dies bedeutet, dass das erste Hubelement insgesamt eine größere Fläche aufweist als das zweite Hubelement. Dabei ist jeweils eine Fläche des Hubelements maßgeblich, die sich in einer Ebene erstreckt, welche senkrecht zu der vertikalen Verschieberichtung der Hubelemente orientiert ist. Diese Ebene, welche parallel zu der Transportrichtung orientiert ist, wird auch als Transportebene der Substrate bezeichnet.

Durch die beschriebene Asymmetrie der gesamten Hubvorrichtung können somit unterschiedlich große Substrate unabhängig voneinander in eine Bestückvorrichtung transportiert und in den entsprechenden Bestückbereichen von den Hubelementen vor einem unerwünschten Durchbiegen geschützt werden.

Um einem Kunden wie beispielsweise einem Betreiber einer Bestückanlage eine besonders hohe Flexibilität bei der Bestückung von unterschiedlich großen Substraten zu ermöglichen, können die beiden Hubelemente in einem Satz von unterschiedlichen Paaren von Hubelementen angeboten werden. Der Kunde kann dann abhängig von der Asymmetrie bzgl. der Größe zweier ungleich großer Substrate ein geeignetes Paar von Hubelementen auswählen. Die Hubelemente können beispielsweise in einem unsymmetrischen Raster von 50 mm mit Breiten von 400 mm bzw. 100 mm, 350 mm bzw. 150 mm und 300 mm bzw. 200 mm angeboten werden. Selbstverständlich können auch Hubelemente mit anderen Breiten angeboten werden.

Gemäß einem weiteren Ausführungsbeispiel der Erfindung nach Anspruch 5 weist das erste Hubelement in Bezug auf das zweite Hubelement eine Auskragung auf. Dies bedeutet, dass in der oben genannten Transportebene zumindest ein Teil des ersten Hubelements in das zweite Hubelement hineinragt.

Eine derartige Verschachtelung der beiden Hubelemente untereinander hat den Vorteil, dass zur unabhängigen Positionierung der beiden ungleichen Hubelemente Vertikalantriebe verwendet werden können, die bei herkömmlichen Bestückvorrichtungen ohnehin vorhanden sind. Diese Vertikalantriebe sind üblicherweise so angeordnet, dass sie jeweils an den Ecken von herkömmlichen Hubelementen angreifen. Solche herkömmlichen Hubelemente sind typischerweise symmetrisch zueinander ausgebildet und weisen in Bezug auf die oben genannte Transportebene die gleiche Größe auf.

Gemäß einem weiteren Ausführungsbeispiel der Erfindung nach Anspruch 6 weisen die beiden Hubelemente senkrecht zur Transportrichtung die gleiche Breite auf. Ferner ist zumindest ein erstes Unterstützungselement des ersten Hubelements derart eingerichtet, dass ein zweites Substrat durch dieses erste Unterstützungselement unterstützt werden kann.

Dies bedeutet, dass bei einem unsymmetrischen Transportsystem ein vollständig unabhängiges Unterstützen von verschieden großen Substraten auch dann durchgeführt werden kann, wenn ein Paar von herkömmlichen Hubelementen bzw. Hubtischplatten verwendet wird. Diese herkömmlichen Hubelemente sind typischerweise symmetrisch zu der Längsmittelachse des gesamten Transportsystems angeordnet. Die Verwendung von herkömmlichen symmetrischen Hubelementen hat den Vorteil, die beschrieben unsymmetrische Hubvorrichtung auf besonders einfache Weise durch entsprechend geformte Unterstützungselemente realisiert werden kann.

Die erforderliche räumliche Asymmetrie der Substratunterstützung wird gemäß dem hier beschriebenen Ausführungsbeispiel durch eine geeignete Ausbildung von zumindest einem ersten Unterstützungselement realisiert.

Gemäß einem weiteren Ausführungsbeispiel der Erfindung nach Anspruch 7 ist das zumindest eine erste Unterstützungselement derart geformt, dass es in den Bereich des zweiten Hubelements hinüber ragt. Das genannte erste Unterstützungselement weist somit eine Auskragung auf. Diese Auskragung bewirkt, dass dieses erste Unterstützungselement, obwohl es an dem ersten Hubelement befestigt ist, ein zweites Substrat unterstützen kann, welches sich oberhalb des zweiten Hubelements befindet.

Gemäß einem weiteren Ausführungsbeispiel der Erfindung nach Anspruch 8 umfasst die Hubvorrichtung zusätzlich ein an dem ersten Hubelement befestigtes Auslegerelement. Dieses Auslegerelement erstreckt sich bis in den Bereich der zweiten Transportspur und weist in dem Bereich der zweiten Transportspur ein versetztes erstes Mitnehmerelement auf. Das erste Mitnehmerelement wirkt bei einem Anheben des ersten Hubelements mit einer versetzten ersten Klemmeinrichtung derart zusammen, dass ein erstes Substrat in einer ersten Bestückposition fixierbar ist.

Dies hat den Vorteil, dass ein in der ersten Transportspur befindliches erstes Substrat auch dann zuverlässig in einer Bestückposition fixiert werden kann, wenn das erste Substrat größer ist als das erste Hubelement und sich somit bis in den Bereich des zweiten Hubelements erstreckt. Dabei wird auf vorteilhafte Weise für die Fixierung mittels des versetzten ersten Klemmelements kein eigener Antrieb benötigt.

Es wird darauf hingewiesen, dass zur Fixierung eines ersten Substrates auch ein weiteres versetztes erstes Mitnehmerelement in Verbindung mit einer weiteren versetzten ersten Klemmeinrichtung verwendet werden kann, wobei das weitere versetzte erste Mitnehmerelement bevorzugt an einem weiteren Auslegerelement angebracht ist. Dabei erfolgt die Fixierung mit der versetzten ersten Klemmeinrichtung und die Fixierung mit der weiteren versetzten ersten Klemmeinrichtung bevorzugt an einander gegenüber liegenden Seiten des in der Bestückposition befindlichen ersten Substrates.

Selbstverständlich können zur Fixierung eines ersten Substrates auch noch weitere Klemmeinrichtungen verwendet werden, die sich im Bereich des ersten Hubelements befinden und somit auf mechanisch einfache Weise durch eine Positionierung des ersten Hubelements betätigt werden können.

Gemäß einem weiteren Ausführungsbeispiel der Erfindung nach Anspruch 9 weist die Hubvorrichtung zusätzlich auf (a) eine versetzte erste Klemmeinrichtung, welche im Bereich des zweiten Hubelements angeordnet ist, und (b) einen Antrieb, welcher mit der versetzten ersten Klemmeinrichtung derart zusammenwirkt, dass ein in der ersten Transportspur befindliches erstes Substrat fixierbar ist.

Auch im Falle einer durch einen separaten Antrieb betätigten versetzten ersten Klemmeinrichtung kann die Fixierung eines ersten Substrates auch durch weitere Klemmeinrichtungen verbessert werden, die im Bereich des ersten Hubelements und/oder im Bereich des zweiten Hubelements angeordnet sind. Die Fixierung eines ersten Substrates erfolgt dabei bevorzugt an einander gegenüber liegenden Seiten des in der Bestückposition befindlichen ersten Substrates.

Es wird darauf hingewiesen, dass ein vollständig unabhängiger Betrieb der beiden Transportspuren bzw. der beiden Hubelemente darauf beruht, dass ein in der ersten Transportspur befindliches erstes Substrat unabhängig von einem in der zweiten Transportspur befindlichen zweiten Substrat fixiert werden kann. Dies bedeutet, dass sämtliche der ersten Transportspur zugeordneten ersten Klemmeinrichtungen in synchronisierter Weise mit der Positionierung des ersten Hubelements betrieben werden. Dies gilt selbstverständlich auch für die durch den separaten Antrieb betätigte versetzte erste Klemmeinrichtung.

Mit dem nebengeordneten Anspruch 10 wird ein Transportsystem zum Transportieren von Substraten entlang einer Transportrichtung beschrieben. Das Transportsystem, welches insbesondere zum Transportieren von Substraten in einer Bestückvorrichtung zum automatischen Bestücken der Substrate mit Bauelementen geeignet ist, weist auf (a) eine erste Transportspur mit einer ersten Spurbreite zum Transport von ersten Substraten, (b) eine zweite Transportspur mit einer zu der ersten Spurbreite unterschiedlichen zweiten Spurbreite zum Transport von zweiten Substraten und (c) eine Hubvorrichtung gemäß einem der oben beschriebenen Ausführungsbeispiele.

Mit dem nebengeordneten Anspruch 11 wird eine Bestückvorrichtung zum automatischen Bestücken von Substraten mit Bauelementen beschrieben. Die Bestückvorrichtung weist ein Transportsystem, wie oben beschrieben, auf.

Weitere Vorteile und Merkmale der vorliegenden Erfindung ergeben sich aus der folgenden beispielhaften Beschreibung derzeit bevorzugter Ausführungsformen. Die einzelnen Figuren der Zeichnung dieser Anmeldung sind lediglich als schematisch und als nicht maßstabsgetreu anzusehen.

Die Figuren 1a, 1b und 1c zeigen jeweils eine asymmetrisch aufgebaute Hubvorrichtung mit zwei unterschiedlich geformten Hubtischplatten.

Die Figur 2 zeigt eine Hubvorrichtung, welche zwei gleich große Hubtischplatten aufweist, wobei an der einen Hubtischplatte Unterstützungselemente angebracht sind, die in den Bereich der anderen Hubtischplatte auskragen.

An dieser Stelle bleibt anzumerken, dass sich in der Zeichnung die Bezugszeichen von gleichen oder von einander entsprechenden Komponenten lediglich in ihrer ersten Ziffer unterscheiden.

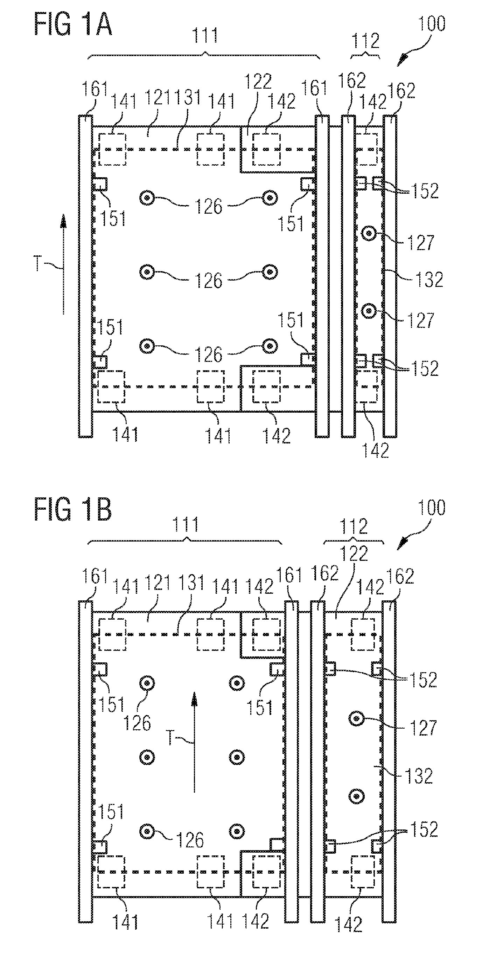

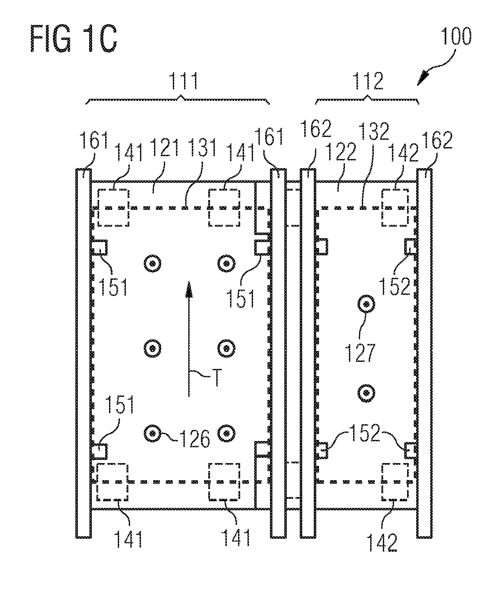

Die Figuren 1a, 1b und 1c zeigen jeweils eine asymmetrisch aufgebaute Hubvorrichtung 100 mit zwei unterschiedlich geformten Hubelementen, einer ersten breiteren Hubtischplatte 121 und einer zweiten schmaleren Hubtischplatte 122. Die erste Hubtischplatte 121 ist hinsichtlich Ihrer Breite senkrecht zu einer Transportrichtung T an die Breite einer ersten Transportspur 111 angepasst.

Auf der ersten Hubtischplatte 121 sind eine Mehrzahl von ersten Unterstützungselementen 126 angeordnet. Die ersten Unterstützungselementen 126 dienen dazu, ein über die erste Transportspur 111 zugeführtes erstes Substrat 131 zu unterstützen, wenn sich das erste Substrat 131, wie in den Figuren 1a, 1b und 1c dargestellt, in einer Bestückposition befindet. In der Bestückposition kann das Substrat 131 mit nicht dargestellten elektronischen Bauelementen bestückt werden.

Auf der zweiten Hubtischplatte 122 sind eine Mehrzahl von zweiten Unterstützungselementen 127 angeordnet. Die zweiten Unterstützungselemente 127 dienen dazu, ein über die zweite Transportspur 112 zugeführtes zweites Substrat 132 zu unterstützen, wenn sich das zweite Substrat 132, wie in den Figuren 1a, 1b und 1c dargestellt, in einer Bestückposition befindet, in der das Substrat 132 mit nicht dargestellten elektronischen Bauelementen bestückt wird.

Das Unterstützen der Substrate 131 bzw. 132 erfolgt dadurch, dass die Hubtischplatte 121 bzw. 122 von unten an das Substrat 131 bzw. 132 angehoben wird, so dass die ersten Unterstützungselemente 126 bzw. die zweiten Unterstützungselemente 127 an der Unterseite des Substrates 131 bzw. 132 anliegen und so ein ungewolltes Durchbiegen des Substrates 131 bzw. 132 verhindern. Gemäß dem hier dargestellten Ausführungsbeispiel sind die Unterstützungselemente 131, 132 Stifte mit einer Länge von ca. 90 mm und einem Durchmesser von ca. 8 mm. Die Unterstützungselemente 131, 132 weisen ferner jeweils einen Magnetfuß auf, so dass die Position der Unterstützungselemente 131, 132 auf der jeweiligen Hubtischplatte 121 bzw. 122 frei gewählt werden kann. Auf diese Weise kann die Unterstützung des jeweiligen Substrates 131, 132 an geeigneten Stellen abseits von evtl. an der Unterseite der Substrate 131, 132 bereits bestückten Bauelementen oder sonstigen Aufbauten erfolgen.

Um ein zuverlässiges Zuführen von Substraten zu gewährleisten, sind für jede der beiden Transportspuren 111 und 122 jeweils zwei Seitenschienen vorgesehen. Die beiden Seitenschienen 161 dienen dabei einer Führung des ersten Substrates 131. Die beiden Seitenschienen 162 dienen einer Führung des zweiten Substrates 132.

Das Anheben der ersten Hubtischplatte 121 erfolgt mittels vier ersten Vertikalantrieben 141. Das Anheben der zweiten Hubtischplatte 122 erfolgt mittels vier zweiten Vertikalantrieben 142. Wie aus den Figuren 1a, 1b und 1c ersichtlich, sind diese Vertikalantriebe unabhängig von dem Verhältnis der Breiten der beiden Transportspuren 111 und 112 stets an der selben Stelle angeordnet. Dies gilt auch für eine nicht dargestellte herkömmliche symmetrische Hubvorrichtung, bei der beide Hubtischplatten die gleiche Breite aufweisen.

Dies bedeutet, dass die beiden Hubtischplatten 121 und 122 unabhängig von ihrer tatsächlichen Breite mit in herkömmlicher Weise angeordneten Vertikalantrieben für eine symmetrische Hubtischplattenanordnung kompatibel sind. Die mit den hier dargestellten Ausführungsbeispielen beschriebenen asymmetrischen Hubvorrichtungen 100 können somit auf einfache Weise in bereits bekannte Doppel-Transportsysteme bzw. in bereits bekannte Bestückvorrichtungen eingebaut werden.

Dies gilt auch für die Betätigung von nicht dargestellten Klemmeinrichtungen, mit denen die in der Bestückposition befindlichen Substrate fixiert werden, so dass ein versehentliches Verrutschen der Substrate während des Bestückvorgangs verhindert werden kann. Die Betätigung der Klemmeinrichtungen erfolgt in bekannter weise mittels Mitnehmerelementen, die an jeweils einer Hubtischplatte angebracht sind und die bei einem geeigneten Anheben der Hubtischplatten jeweils eine Klemmeinrichtung aktivieren. Auf diese Weise sind für die Klemmeinrichtungen keine eigenen Stellantriebe bzw. Aktuatoren erforderlich.

Wie aus den Figuren 1a, 1b und 1c ersichtlich, weist die erste Hubtischplatte 121 insgesamt vier erste Mitnehmerelemente 151 auf. Die Mitnehmerelemente 151 sind derart angeordnet, dass die entsprechenden nicht dargestellten ersten Klemmeinrichtungen das erste Substrat 131 in der Nähe der vier Ecken des Substrates 131 fixieren können. In entsprechender Weise weist die zweite Hubtischplatte 122 insgesamt vier zweite Mitnehmerelemente 152 auf. Die Mitnehmerelemente 152 sind derart angeordnet, dass die entsprechenden nicht dargestellten zweiten Klemmeinrichtungen das zweite Substrat 132 ebenfalls in der Nähe der vier Ecken des Substrates 132 fixieren können.

Die in den verschiedenen Figuren 1a, 1b und 1c dargestellten Hubvorrichtungen 100 unterscheiden sich somit lediglich durch den Grad ihrer Asymmetrie. Der Asymmetriegrad ist dabei durch das Verhältnis der Breiten der beiden Transportspuren 111 und 112 gegeben. Um unabhängig von diesem Asymmetriegrad die gleichen Vertikalantriebe 141, 142 nutzen zu können, sind die beiden Hubtischplatten 121, 122 ineinander verschachtelt angeordnet. Diese Verschachtelung besteht darin, dass die erste Hubtischplatte 121 eine Auskragung aufweist, die zumindest annähernd exakt in einen entsprechenden Ausschnitt in der zweiten Hubtischplatte 122 eingepasst ist. Auf diese Weise können die beiden Hubtischplatten unabhängig voneinander in vertikaler Richtung, d.h. senkrecht zur Zeichenebene, bewegt werden. Die Breite dieser Auskragung bzw. die Tiefe dieses Ausschnitts ist abhängig von dem Asymmetriegrad der beiden Transportspuren 111 und 112.

Um auf möglichst effiziente Weise verschiedene Breitenverhältnisse abdecken zu können, können verschiedene Paare von Hubtischplatten 121, 122 angeboten werden, die sich jeweils durch den Grad ihrer Asymmetrie unterscheiden. Die in den Figuren 1a, 1b und 1c dargestellten Hubtischplatten 121, 122 weisen dabei ein Breitenraster von 50 mm auf. So weist beispielsweise die in Figur 1a dargestellte Hubtischplatte 121 eine maximale Breite von 400 mm und die entsprechende Hubtischplatte 122 weist eine minimale Breite von 100 mm auf. Die maximale Breite ergibt sich dabei durch die Normalbreite zuzüglich der Breite der Auskragung. Die Normalbreite entspricht der Breite einer Hubtischplatte bei einer symmetrischen Hubvorrichtung. Die minimale Breite ergibt sich aus der Normalbreite abzüglich der Tiefe des Ausschnitts der zweiten Hubtischplatte 122.

Die in Figur 1b dargestellte Hubtischplatte 121 weist eine maximale Breite von 350 mm und die entsprechende Hubtischplatte 122 weist eine minimale Breite von 150 mm auf. Die in Figur 1c dargestellte Hubtischplatte 121 weist eine maximale Breite von 300 mm und die entsprechende Hubtischplatte 122 weist eine minimale Breite von 200 mm auf. Die Hubtischplatten 121, 122 sind paarweise wechselbar, so dass die gesamte Hubanordnung 100 auf einfache Weise an verschiedene Breiten der Transportspuren 121 und 122 angepasst werden kann.

Die beiden Hubtische 121 und 122 sind unabhängig voneinander betreibbar. Dies gilt im Gegensatz zu bekannten Lösungen auch dann, wenn deutlich unterschiedlich große Substrate gemeinsam in einer Bestückvorrichtung bestückt werden, wobei ein Substrat ein Breite aufweist, die größer ist als die halbe Breite des gesamten Doppel-Transportsystems. Somit kann ein Doppel-Transportsystem auch bei stark unterschiedlich großen Substraten einem vollständig asynchronen Betriebsmodus betrieben werden. Die Produktivität der Bestückvorrichtung kann somit erheblich erhöht werden. Dies gilt insbesondere im Vergleich zu einem bekannten Betriebsmodus, bei dem im Falle der Bestückung eines Substrates mit einer Breite größer als die halbe Breite des gesamten Doppel-Transportsystems die zweite Transportspur gar nicht genutzt werden kann.

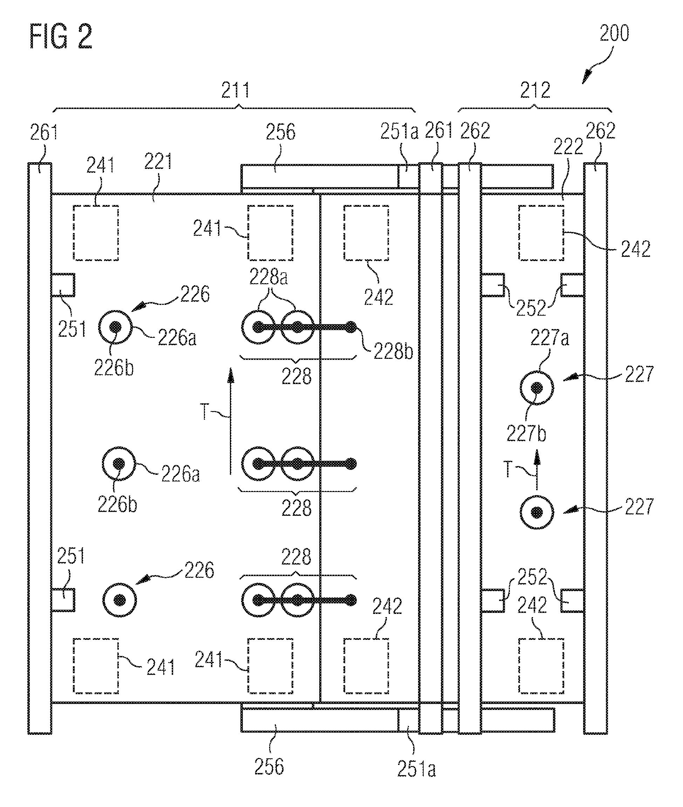

Figur 2 zeigt eine Hubvorrichtung 200, welche zwei gleich große Hubtischplatten aufweist. Eine erste Hubtischplatte 221 ist einer ersten Transportspur 211 eines nicht näher dargestellten Doppel-Transportsystems zugeordnet. Eine zweite Hubtischplatte 222 ist einer zweiten Transportspur 212 des Doppel-Transportsystems zugeordnet. In der ersten Transportspur 211 können nicht dargestellte erste Substrate entlang einer Transportrichtung T transportiert werden. Die erste Transportspur 211 wird lateral durch zwei Seitenschienen 261 begrenzt. In der zweiten Transportspur 212 können ebenfalls nicht dargestellte zweite Substrate entlang der gleichen Transportrichtung T transportiert werden. Die zweite Transportspur 212 wird lateral durch zwei Seitenschienen 262 begrenzt.

Ein erstes Substrat, welches entsprechend der Breite der ersten Transportspur 211 bis in den Bereich der zweiten Hubtischplatte 222 hinüber ragt, wird gemäß dem hier dargestellten Ausführungsbeispiel in der Bestückposition von drei ersten Unterstützungselementen 226 unterstützt. Die Unterstützungselemente 226 weisen jeweils einen Magnetfuß 226a und einen Stift 226b auf. Der in den Bereich der zweiten Hubtischplatte 222 hinüberragende Teil des ersten Substrates wird von drei auskragenden Unterstützungselementen 228 unterstützt, welche jeweils zwei Magnetfüße 228a und einen auskragenden Stift 228b aufweisen. Die beiden Magnetfüße sorgen dabei für einen sicheren Halt an der ein magnetisches Material aufweisenden ersten Hubtischplatte 221. Die Magnetkräfte sind dabei so groß, dass eine Belastung des auskragenden Endes des Stiftes 228b, welches ein Drehmoment erzeugt, nicht zu einem Ablösen insbesondere des linken Magenfußes 228a führt.

Ein zweites Substrat, welches entsprechend der Breite der zweiten Transportspur 212 deutlich schmaler ist als das erste Substrat, wird gemäß dem hier dargestellten Ausführungsbeispiel in der Bestückposition von zwei zweiten Unterstützungselementen 227 unterstützt. Die zweiten Unterstützungselemente 227 weisen jeweils einen Magnetfuß 227a und einen Stift 227b auf.

Die beiden Hubtischplatten 241 und 242 werden ebenso wie bei der mit den Figuren 1a, 1b und 1c dargestellten Hubvorrichtung 100 von jeweils vier Vertikalantrieben angetrieben. Vier erste Vertikalantriebe 241 werden zum Heben und Senken der ersten Hubtischplatte 221 verwendet, vier zweite Vertikalantriebe 242 werden zum Heben und Senken der zweiten Hubtischplatte 222 verwendet.

Wie aus Figur 2 ersichtlich, sind an der ersten Hubtischplatte 221 zwei Ausleger 256 angebracht. Ein Ausleger 256 ist in Bezug auf die Transportrichtung T stromaufwärts und ein Ausleger 256 ist stromabwärts angeordnet. An den beiden Auslegern ist jeweils ein versetztes erstes Mitnehmerelement 251 angeformt, welches bei einer entsprechenden Positionierung der ersten Hubtischplatte 221 jeweils eine nicht dargestellte versetzte erste Klemmeinrichtung betätigt. Diese sorgt bei einer entsprechenden Positionierung der ersten Hubtischplatte 221 zusammen mit zwei ebenfalls nicht dargestellten ersten Klemmeinrichtungen, die von zwei ersten Mitnehmerelementen 251 betätigt werden, für eine sichere Fixierung des ersten Substrates in der Bestückposition.

Die Fixierung des zweiten Substrates in der Bestückposition erfolgt auf analoge Weise mittels vier zweiten Mitnehmerelementen 252, die jeweils eine zweite ebenfalls nicht dargestellte Klemmeinrichtung betätigen.

Auch bei der in Figur 2 dargestellten Hubvorrichtung können die beiden Hubtischplatten völlig unabhängig voneinander angehoben und abgesenkt werden. Die für eine zuverlässige Abstützung der unterschiedlich großen Substrate erforderliche Asymmetrie wird bei der Hubvorrichtung 200 durch die auskragenden Unterstützungselementen 228 erreicht.

Es wird darauf hingewiesen, dass die hier beschriebenen Ausführungsformen lediglich eine beschränkte Auswahl an möglichen Ausführungsvarianten der Erfindung darstellen. So ist es möglich, die Merkmale einzelner Ausführungsformen in geeigneter Weise miteinander zu kombinieren, so dass für den Fachmann mit den hier expliziten Ausführungsvarianten eine Vielzahl von verschiedenen Ausführungsformen als offensichtlich offenbart anzusehen sind.

### Bezugszeichenliste

- 100: Hubvorrichtung
- 111: erste Transportspur
- 112: zweite Transportspur
- 121: erstes Hubelement / erste Hubtischplatte
- 122: zweites Hubelement / zweite Hubtischplatte
- 126: erstes Unterstützungselement
- 127: zweites Unterstützungselement
- 131: erstes Substrat
- 132: zweites Substrat
- 141: erster Vertikalantrieb
- 142: zweiter Vertikalantrieb
- 151: erstes Mitnehmerelement
- 152: zweites Mitnehmerelement
- 161: Seitenschiene
- 162: Seitenschiene
- T: Transportrichtung

- 200: Hubvorrichtung
- 211: erste Transportspur
- 212: zweite Transportspur
- 221: erstes Hubelement / erste Hubtischplatte
- 222: zweites Hubelement / zweite Hubtischplatte
- 226: erstes Unterstützungselement
- 226a: Magnetfuß
- 226b: Stift
- 227: zweites Unterstützungselement
- 227a: Magnetfuß
- 227b: Stift
- 228: erstes Unterstützungselement / auskragendes Unterstützungselement
- 228a: Magnetfuß
- 228b: auskragender Stift
- 241: erster Vertikalantrieb
- 242: zweiter Vertikalantrieb
- 251: erstes Mitnehmerelement
- 251a: versetztes erstes Mitnehmerelement
- 252: zweites Mitnehmerelement
- 256: Ausleger
- 261: Seitenschiene
- 262: Seitenschiene
- T: Transportrichtung

## Patentansprüche

1. Hubvorrichtung für ein Transportsystem zum Transportieren von Substraten (131, 132) entlang einer Transportrichtung (T), insbesondere zum Transportieren von Substraten (131, 132) in einer Bestückvorrichtung zum automatischen Bestücken der Substrate (131, 132) mit Bauelementen, wobei das Transportsystem
eine erste Transportspur (111, 211) mit einer ersten Spurbreite zum Transport von ersten Substraten (131) und
eine zweite Transportspur (112, 212) mit einer zu der ersten Spurbreite unterschiedlichen zweiten Spurbreite zum Transport von zweiten Substraten (132)
aufweist, die Hubvorrichtung (100, 200) aufweisend
• ein erstes Hubelement (121, 221), welches der ersten Transportspur (111, 211) des Transportsystems zugeordnet ist,
• ein zweites Hubelement (122, 222), welches der zweiten Transportspur (112, 212) des Transportsystems zugeordnet ist,
• zumindest ein erstes Unterstützungselement (126, 226, 228), welches an dem ersten Hubelement (121, 221) angebracht ist und welches derart eingerichtet ist, bei einer geeigneten Positionierung des ersten Hubelements (121, 221) ein erstes Substrat (131) zu unterstützen, und
• zumindest ein zweites Unterstützungselement (127, 227), welches an dem zweiten Hubelement (122, 222) angebracht ist und welches derart eingerichtet ist, bei einer geeigneten Positionierung des zweiten Hubelements (122, 222) ein zweites Substrat (132) zu unterstützen,
wobei
die beiden Hubelemente (121, 122, 221, 222) unabhängig voneinander positionierbar sind.

2. Hubvorrichtung nach Anspruch 1, zusätzlich aufweisend
• zumindest einen ersten Vertikalantrieb (141, 241), eingerichtet zum vertikalen Positionieren des ersten Hubelements (121, 221) und
• zumindest einen zweiten Vertikalantrieb (142, 242), eingerichtet zum vertikalen Positionieren des zweiten Hubelements (122, 222),
wobei der
erste Vertikalantrieb (141, 241) und der zweite Vertikalantrieb (142, 242) in Bezug auf eine Längsmittelachse des Transportsystems symmetrisch zueinander angeordnet sind.

3. Hubvorrichtung nach einem der Ansprüche 1 bis 2, zusätzlich aufweisend
• zumindest eine erste Klemmeinrichtung und ein erstes Mitnehmerelement (151, 251, 251a), welche bei einem Anheben des ersten Hubelements (121, 221) derart zusammenwirken, dass ein erstes Substrat (131) in einer ersten Bestückposition fixierbar ist, und
• zumindest eine zweite Klemmeinrichtung und ein zweites Mitnehmerelement (152, 252), welche bei einem Anheben des zweiten Hubelements (122, 222) derart zusammenwirken, dass ein zweites Substrat (132) in einer zweiten Bestückposition fixierbar ist.

4. Hubvorrichtung nach einem der Ansprüche 1 bis 3, wobei das erste Hubelement (121) zumindest in Teilbereichen senkrecht zur Transportrichtung (T) eine größere Breite aufweist als das zweite Hubelement (122).

5. Hubvorrichtung nach Anspruch 4, wobei
das erste Hubelement (121) in Bezug auf das zweite Hubelement (122) eine Auskragung aufweist.

6. Hubvorrichtung nach einem der Ansprüche 1 bis 3, wobei die beiden Hubelemente (221, 222) senkrecht zur Transportrichtung (T) die gleiche Breite aufweisen und wobei zumindest ein erstes Unterstützungselement (228) des ersten Hubelements (221) eingerichtet ist, das zweite Substrat zu unterstützen.

7. Hubvorrichtung nach Anspruch 6, wobei das zumindest ein erstes Unterstützungselement (228) derart geformt ist, dass es in den Bereich des zweiten Hubelements (222) hinüber ragt.

8. Hubvorrichtung nach einem der Ansprüche 6 bis 7, zusätzlich aufweisend
• ein an dem ersten Hubelement (221) befestigtes Auslegerelement (256), welches sich bis in den Bereich der zweiten Transportspur (212) erstreckt und welches in dem Bereich der zweiten Transportspur (212) ein versetztes erstes Mitnehmerelement (251a) aufweist, das bei einem Anheben des ersten Hubelements (221) mit einer versetzten ersten Klemmeinrichtung derart zusammenwirkt, dass ein erstes Substrat in einer ersten Bestückposition fixierbar ist.

9. Hubvorrichtung nach einem der Ansprüche 6 bis 7, zusätzlich aufweisend
• eine versetzte erste Klemmeinrichtung, welche im Bereich des zweiten Hubelements (212) angeordnet ist, und
• einen Antrieb, welcher mit der versetzten ersten Klemmeinrichtung derart zusammenwirkt, dass ein in der ersten Transportspur (211) befindliches erstes Substrat fixierbar ist.

10. Transportsystem zum Transportieren von Substraten entlang einer Transportrichtung, insbesondere zum Transportieren von Substraten (131, 132) in einer Bestückvorrichtung zum automatischen Bestücken der Substrate (131, 132) mit Bauelementen, das Transportsystem aufweisend
• eine erste Transportspur (111, 211) mit einer ersten Spurbreite zum Transport von ersten Substraten (131),
• eine zweite Transportspur (112, 212) mit einer zu der ersten Spurbreite unterschiedlichen zweiten Spurbreite zum Transport von zweiten Substraten (132) und
• eine Hubvorrichtung (100, 200) nach einem der Ansprüche 1 bis 9.

11. Bestückvorrichtung zum automatischen Bestücken von Substraten mit Bauelementen, die Bestückvorrichtung aufweisend ein Transportsystem nach Anspruch 10.
